# EUROPEAN PATENT SPECIFICATION

(11) **EP 1 519 309 B1**
(45) Date of publication and mention of the grant of the patent: **15.03.2006**
(21) Application number: 04022209.3
(22) Date of filing: 17.09.2004
(51) Int. Cl.: G06K 19/077, H01L 21/58, H01L 21/60

(54) **Radio card with a reinforced chip**
Funkkarte mit einem verstärktem Chip
Carte radio avec une puce renforcée

(30) Priority: 25.09.2003 JP 2003334155
(43) Date of publication of application: 30.03.2005
(73) Proprietor: KABUSHIKI KAISHA TOSHIBA, Tokyo 105-8001 (JP)
(72) Inventor: Murohara, Masaru, c/o Toshiba Corporation, Minato-ku Tokyo 105-8001 (JP)
(74) Representative: Kramer - Barske - Schmidtchen

(56) References cited:
- EP-A- 0 929 097
- WO-A-01/50415
- PATENT ABSTRACTS OF JAPAN vol. 2003, no. 04, 2 April 2003 (2003-04-02) & JP 2002 366922 A (SONY CORP), 20 December 2002 (2002-12-20)

## Description

The present invention relates to an LSI-equipped radio card.

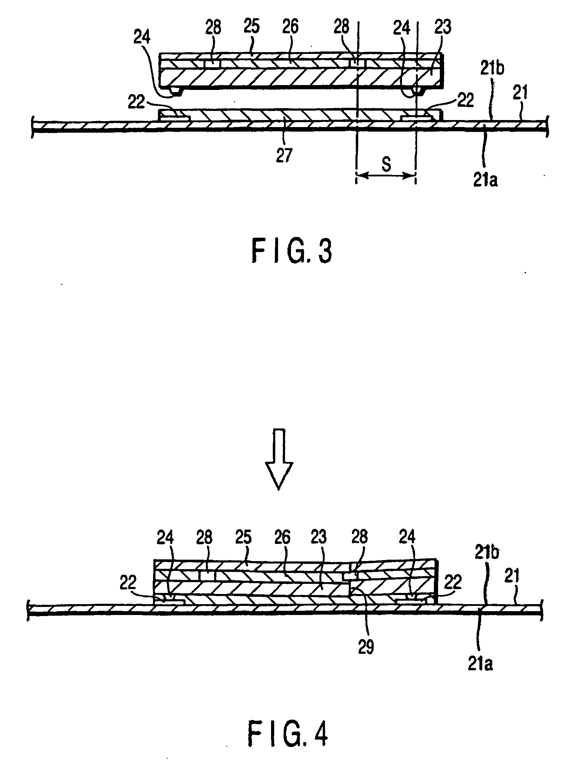

As a radio card of this kind, for example, a card as shown in FIG. 3 is known.

In FIG. 3, reference numeral 21 denotes a board. The board 21 comprises a base material 21a and an antenna pattern 21b. As the base material 21a, polyethylene terephthalate (hereinafter referred to as "PET") having a 0.05 mm thickness is used. An aluminum foil having a 0.038 mm thickness is used for the antenna pattern 21b, and wire is formed by etching the aluminum foil.

On each of the terminals 22 of the antenna pattern 21b in the board 21, a bump 24 of an LSI 23 is mounted in a flip chip manner. The LSI 23 is electrically connected to the board 21, with an anisotropic conductive film 27 interposed therebetween.

The radio card configured as described above converts radio waves provided from the outside into electric power to operate the LSI 23, and sends back a response with remaining electric power. Thereby, the radio card performs noncontact data communications.

In the meantime, to improve the point-pressure strength and the resistance to bending stress, a reinforcing board 25 such as a SUS board is bonded to the LSI 23 by an adhesive 26 to form one unitary piece.

Further, the reinforcing board 25 is provided with projection ribs 28. The reinforcing board 25 is bonded to the LSI 23 with the ribs 28 interposed therebetween. The amount of the adhesive 26 interposed between the LSI 23 and the reinforcing board 25 is determined according to the height of the ribs 28, to maintain the thickness uniform after bonding.

However, in prior art, the bumps 24 of the PSI 23 are provided in positions distant from the ribs 28 of the reinforcing board 25 by, for example, a distance S in the surface direction of the LSI 23. Therefore, when the LSI 23 is mounted, if pressure is applied to the LSI 23 through the ribs 28 of the reinforcing board 25, the problem arises that bending stress occurs and causes a crack 29 in the LSI 23 as shown in FIG. 4.

The present invention has been made in consideration of the above circumstances. The object of the present invention is to provide a radio card in which no crack occurs in its LSI when the LSI is mounted.

A radio card according to an aspect of the present invention comprises: a board; an LSI having a bump on one surface thereof and mounted on the board with the bump interposed therebetween; a reinforcing member which has a projecting portion and is bonded to the other surface of the LSI with the projecting portion interposed therebetween, the bump of the LSI and the projecting portion being located above each other almost on a straight line, the line being orthogonal to a surface direction of the LSI; and an adhesive interposed between the reinforcing member and the other surface of the LSI, and bonding the reinforcing member to the LSI.

A radio card according to another aspect of the present invention comprises: a board; an LSI having a bump on one surface thereof and a projecting portion on the other surface thereof and mounted on the board with the bump interposed therebetween, the bump and the projecting portion being located above each other almost on a straight line, the line being orthogonal to a surface direction of the LSI; a reinforcing member bonded to the other surface of the LSI with the projecting portion interposed therebetween; and an adhesive interposed between the reinforcing member and the LSI, and bonding the reinforcing member to the LSI.

According to aspects of the present invention, the pressure generated in mounting the LSI can be directly transmitted from projecting portions of the reinforcing member or projecting portions of the LSI to the bumps of the LSI, and occurrence of a crack in the LSI due to bending stress is prevented.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a cross-sectional view of a radio card according to a first embodiment of the present invention.
FIG. 2 is a cross-sectional view of a radio card according to a second embodiment of the present invention.
FIG. 3 is a cross-sectional view of a conventional radio card.
FIG. 4 is a diagram illustrating the state where a crack occurs in an LSI of the conventional radio card.

The present invention is explained in detail below, with reference to embodiments shown in drawings.

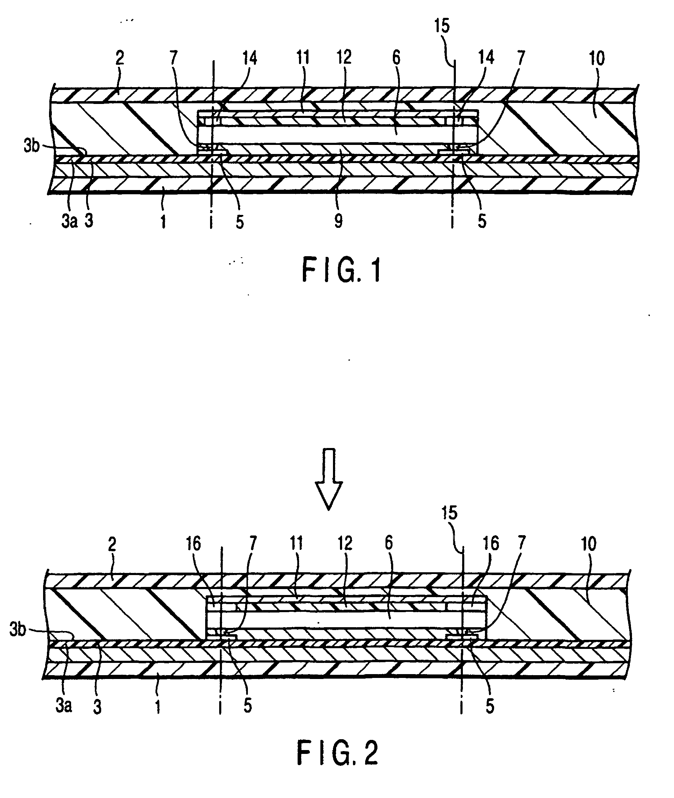

FIG. 1 is a cross-sectional view of a radio card according to a first embodiment of the present invention.

The radio card converts radio waves provided from the outside into electric power to operate an LSI, sends back a response with remaining electric power, and thereby performs noncontact data communications.

The radio card has a front sheet 1 and a back sheet 2. A board 3 is provided between the front and back sheets 1 and 2. The board 3 comprises a base material 3a and an antenna pattern 3b. As the base material 3a, polyethylene terephthalate (hereinafter referred to as "PET") having a 0.05 mm thickness is used. An aluminum foil having a 0.038 mm thickness is used for the antenna pattern 3b, and wire is formed by etching the aluminum foil.

Bumps 7 of LSI 6 are mounted on both respective terminals 5 of the antenna pattern 3b of the board 3 in a flip-chip manner. The LSI 6 is electrically connected to the board 3 with an anisotropic conductive film 9 interposed therebetween. Further, a filler 10 is filled into the space between the front and back sheets 1 and 2.

In the meantime, an SUS board 11 serving as a reinforcing member is bonded to a back surface of the LSI 6 by adhesive 12 to form one unitary piece. The SUS board 11 has almost the same size as that of the LSI 6, and a thickness of 100 µm.

Further, ribs 14 each having a 30 µm height are formed in the four corners and the center of the SUS board 11 by etching. The height of the ribs 14 determines the space between the LSI 6 and the SUS board 11. Thereby, the amount of the adhesive 12 is determined, and the thickness of the LSI 6 with the reinforcing SUS after curing of the adhesive is determined. The ribs 14 of the SUS board 11 may be formed by pressurization or heat transformation, instead of etching. Further, the ribs 14 and the bumps 7 are formed in almost the same shape.

In the meantime, the ribs 14 of the SUS board 11 and the bumps 7 of the LSI 16 are arranged so as to be located on lines (vertical lines in FIG. 1) 15 which are orthogonal to the surface direction of the LSI 6. The ribs 14 are located above the bumps 7.

Recently, the SUS board 11 is formed with a greater thickness to enhance the reinforcing strength of the LSI 6, and the LSI 6 is thinned correspondingly. Therefore, the radio card is in the state where a crack easily occurs in the LSI 6 due to pressure occurring when the LSI is mounted.

However, since the ribs 14 of the SUS board 11 are arranged above the bumps 7 of the LSI 6 as described above, the pressure occurring in mounting the LSI is directly transmitted from the ribs 14 to the bumps 7 through the LSI 6. Therefore, no large bending stress occurs in the LSI 6, and occurrence of a crack is prevented.

FIG. 2 is a cross-sectional view of a radio card according to a second embodiment of the present invention.

In FIG. 2, the same constituent elements as those shown in the above first embodiment are denoted by the same respective reference numerals, and their explanations are omitted.

In the above first embodiment, the ribs 14 are formed on the SUS board 11. In the second embodiment, ribs 16 are formed on a back surface of the LSI 6 by etching the LSI 6. Bumps 7 have a different shape from that of the ribs 16.

Also in this embodiment, the bumps 7 and the ribs 16 are arranged so as to be located on lines 15, in the same manner as the above embodiment. Thereby, the pressure in mounting the LSI is directly transmitted from the ribs 16 to the bumps 7 via the LSI 6, and occurrence of a crack in the LSI 6 is prevented.

In the above embodiments, as long as the pressure in mounting the LSI 6 is directly transmitted to the bumps 7 through the ribs 14 or 16, the ribs 14 and 16 are not necessarily accurately located directly above the bumps 7, but may be located slightly off the lines.

Further, the present invention can be variously modified and carried out within the range of the gist of the invention as a matter of course.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A radio card comprising:
a board (3);
an LSI (6) having a bump (7) on one surface thereof, and mounted on the board (3) with the bump (7) interposed therebetween;
a reinforcing member (11) which has a projecting portion (14) and is bonded to the other surface of the LSI (6) with the projecting portion (14) interposed therebetween; and
an adhesive (12) interposed between the reinforcing member (11) and the other surface of the LSI (6), and bonding the reinforcing member (11) to the LSI (6),
**characterized in that** the bump (7) of the LSI (6) and the projecting portion (14) of the reinforcing member (11) are located above each other almost on a straight line (15), the straight line (15) being orthogonal to a surface direction of the LSI (6).

2. A radio card according to claim 1,
**characterized in that** the projecting portion (14) of the reinforcing member (11) is formed by etching, pressurization or heat transformation.

3. A radio card according to claim 1,
**characterized in that** the bump (7) of the LSI (6) and the projecting portion (14) of the reinforcing member (11) are formed in almost the same shape, or different shapes.

4. A radio card comprising:
a board (3);
an LSI (6) having a bump (7) on one surface thereof and a projecting portion (16) on the other surface thereof, and mounted on the board (3) with the bump 7 interposed therebetween;
a reinforcing member (11) bonded to the other surface of the LSI (6) with the projecting portion (16) interposed therebetween; and
an adhesive (12) interposed between the reinforcing member (11) and the LSI (6), and bonding the reinforcing member 11 to the LSI (6),
**characterized in that** the bump (7) and the projecting portion (16) of the LSI (6) are located above each other almost on a straight line (15) being orthogonal to a surface direction of the LSI (6).

5. A radio card according to claim 4,
**characterized in that** the LSI (6) has a wafer and the projecting portion (16) is formed of the wafer.

6. A radio card according to claim 4,
**characterized in that** the bump (7) and the projecting portion (16) of the LSI (6) are formed in almost the same shape, or different shapes.

## Revendications

1. Carte radio comprenant :
une carte (3) ;
un LSI (6) ayant une bosse (7) sur une surface de celui-ci, et monté sur la carte (3) avec la bosse (7) interposée entre elle ;
un élément de renforcement (11) qui a une partie faisant saillie (14) et est soudé à l'autre surface du LSI (6) avec la partie faisant saillie (14) interposée entre elles ; et
un adhésif (12) interposé entre l'élément de renforcement (11) et l'autre surface du LSI (6), et le soudage de l'élément de renforcement (11) au LSI (6),
**caractérisé en ce que** la bosse (7) du LSI (6) et la partie faisant saillie (14) de l'élément de renforcement (11) sont situées l'une au-dessus de l'autre presque sur une ligne droite (15), la ligne droite (15) étant orthogonale à une direction de surface du LSI (6).

2. Carte radio selon la revendication 1, **caractérisé en ce que** la partie faisant saillie (14) de l'élément de renforcement (11) est formée par gravure, mise en pression ou transformation thermique.

3. Carte radio selon la revendication 1, **caractérisé en ce que** la bosse (7) du LSI (6) et la partie faisant saillie (14) de l'élément de renforcement (11) sont formées dans presque la même forme ou des formes différentes.

4. Carte radio comprenant :
une carte (3) ;
un LSI (6) ayant une bosse (7) sur une surface de celui-ci et une partie faisant saillie (16) sur l'autre surface de celui-ci, et monté sur la carte (3) avec une bosse (7) interposée entre elles ;
un élément de renforcement (11) soudé à l'autre surface du LSI (6) avec la partie faisant saillie (16) interposée entre elles ; et
un adhésif (12) interposé entre l'élément de renforcement (11) et le LSI (6), et le soudage de l'élément de renforcement (11) au LSI (6),
**caractérisé en ce que** la bosse (7) et la partie faisant saillie (16) du LSI (6) sont situées l'une au-dessus de l'autre presque sur une ligne droite (15) étant orthogonale à une direction de surface du LSI (6).

5. Carte radio selon la revendication 4, **caractérisé en ce que** le LSI (6) a une plaquette et la partie faisant saillie (16) est formée sur la plaquette.

6. Carte radio selon la revendication 4, **caractérisé en ce que** la bosse (7) et la partie faisant saillie (16) du LSI (6) sont formées dans presque la même forme ou des formes différentes.

## Patentansprüche

1. Funkkarte enthaltend:
ein Board (3);
einen LSI (6), der einen Höcker (7) auf einer seiner Oberflächen aufweist und auf dem Board (3) mit dem Höcker (7) dazwischen liegend montiert ist;
ein verstärkendes Element (11), das einen vorspringenden Bereich (14) aufweist und mit der anderen Oberfläche des LSI (6) verbunden ist, wobei der vorspringende Bereich (14) dazwischen angebracht ist; und
ein Klebemittel (12), das zwischen dem verstärkenden Element (11) und der anderen Oberfläche des LSI (6) liegt und das verstärkende Element (11) mit dem LSI (6) verbindet, **dadurch gekennzeichnet, dass** der Höcker (7) des LSI (6) und der vorspringende Bereich (14) des verstärkenden Elements (11) übereinander nahezu auf einer geraden Linie (15) angeordnet sind, wobei die gerade Linie (15) senkrecht zu einer Oberflächenrichtung des LSI (6) ist.

2. Funkkarte nach Anspruch 1, **dadurch gekennzeichnet, dass** der vorspringende Bereich (14) des verstärkenden Elements (11) durch Ätzen, Druckformung oder Wärmetransformation gebildet ist.

3. Funkkarte nach Anspruch 1, **dadurch gekennzeichnet, dass** der Höcker (7) des LSI (6) und der vorspringende Bereich (14) des verstärkenden Elements (11) in nahezu der gleichen Gestalt ausgebildet sind, oder in unterschiedlichen Gestalten geformt sind.

4. Funkkarte, enthaltend:
ein Board (3);
einen LSI (6), der einen Höcker (7) auf einer seiner Oberflächen aufweist, und einen vorspringenden Bereich (16) auf der anderen Oberfläche aufweist, und der auf dem Board (3) mit dem Höcker (7) dazwischen liegend montiert ist;
ein verstärkendes Element (11), das mit der anderen Oberfläche des LSI (6) verbunden ist, wobei der vorspringende Bereich (16) dazwischen liegt; und
ein Klebemittel (12), das zwischen dem verstärkenden Element (11) und dem LSI (6) eingebracht ist und das verstärkende Element (11) mit dem LSI (6) verbindet,
**dadurch gekennzeichnet, dass** der Höcker (7) und der vorspringende Bereich (16) des LSI (6) übereinander nahezu auf einer geraden Linie (15) angeordnet sind, die senkrecht zu einer Oberflächenrichtung des LSI (6) ist.

5. Funkkarte nach Anspruch 4, **dadurch gekennzeichnet, dass** der LSI (6) einen Wafer aufweist und der vorspringende Bereich (16) aus dem Wafer gebildet ist.

6. Funkkarte nach Anspruch 4, **dadurch gekennzeichnet, dass** der Höcker (7) und der vorspringende Bereich (16) des LSI (6) in nahezu der gleichen Gestalt oder in unterschiedlichen Gestalten geformt sind.
